# EUROPÄISCHE PATENTANMELDUNG

(11) **EP 1 661 872 A2**
(43) Veröffentlichungstag der Anmeldung: **31.05.2006**
(21) Anmeldenummer: 05025030.7
(22) Anmeldetag: 16.11.2005
(51) Int. Cl.: C04B 41/45, H01L 23/12

(54) **Verfahren zur Herstellung keramischer Formkörper mit erhöhter Festigkeit bei niedrigen Temperaturen, danach hergestellte Formkörper und deren Verwendung**

(30) Priorität: 19.11.2004 DE 102004055900
(71) Anmelder: Fraunhofer-Gesellschaft zur Förderung der angewandten Forschung e.V., 80686 München (DE)
(72) Erfinder: Raether, Friedrich, Dr., 97204 Höchberg (DE); Klimera, Andreas, 97246 Eibelstadt (DE)
(74) Vertreter: Pfenning, Meinig & Partner GbR

(57) **Zusammenfassung**

Die vorliegende Erfindung betrifft ein Verfahren zur Herstellung poröser keramischer Formkörper mit erhöhter Festigkeit, bei dem der poröse keramische Formkörper mit einem mindestens eine Komponente des keramischen Materials zumindest teilweise lösenden Lösungsmittel infiltriert wird und im Anschluss zur Verfestigung gelagert wird. Ebenso betrifft die Erfindung entsprechend hergestellte keramische Formkörper sowie deren Verwendung zur Herstellung von Verbundbauteilen mit Polymeren oder Halbleitern bei Temperaturen von ≤ 150 °C.

## Beschreibung

Die vorliegende Erfindung bezieht sich auf ein Verfahren zur Festigkeitssteigerung keramischer Formkörper bei Temperaturen ≤ 150 °C, nach diesem Verfahren hergestellte Formkörper und deren Verwendung.

Keramiken gelten als erste künstliche Werkstoffe, die von Menschenhand geschaffen wurden, und sind seit etwa 10 000 Jahren in Gebrauch. Im klassischen Sinn versteht man unter Keramik Werkstoffe, die dadurch zustande kommen, dass ein Pulver geformt und die Form, der sogenannte Grünkörper, durch Einwirkung hoher Temperaturen gesintert, d. h., verfestigt wird (Haase Th.: Keramik, 2. Aufl. Leipzig: Deutscher Verlag für Grundstoffindustrie 1968).

Eine andere Definition beschreibt keramische Werkstoffe als anorganische, nichtmetallische Materialien, die in Wasser schwer löslich und zu wenigstens zu 30 % kristallin sind. In der Regel werden Keramiken bei Raumtemperatur aus einer Rohmasse geformt und erhalten ihre typischen Werkstoffeigenschaften durch eine Temperaturbehandlung meist über 800 °C. Häufig geschieht die Sinterung bei noch höheren Temperaturen bis zu 1 000 °C oder gar über den Schmelzfluss bei bis zu 1 600 °C mit anschließender Kristallisation (Hennike H. W.: Zum Begriff Keramik und zur Einteilung keramischer Werkstoffe. Ber. Dtsch. Keram. Ges. 44 (1967) 209 - 211).

Beiden Definitionen ist gemeinsam, dass sie die Herstellung keramischer Werkstoffe als typische Hochtemperaturprozesse beschreiben.

Keramiken verfügen neben einer hohen Steifigkeit und chemischen Beständigkeit über spezielle elektrische und thermische Eigenschaften, wegen derer sie als Funktionsmaterialien in der Elektrotechnik und Mikroelektronik eingesetzt werden (Levinson, L. M. (ed.): Electronic ceramics. Marcel Dekker, Inc. New York 1988).

Die Absenkung der Temperatur, die zum Sintern von Keramiken benötigt wird, ist seit Jahrzehnten ein Ziel intensiver Forschungsanstrengungen, um Keramiken mit anderen Materialien gemeinsam zu verarbeiten. Motiviert durch den Innovationssprung, der sich bei Halbleiterbauteilen durch die Entwicklung von Integrierten Schaltkreisen eingestellt hat, wird zur Zeit die integrale Herstellung passiver keramischer Bauteile wie Ohmsche, induktive und/oder kapazitive Widerstände zusammen mit den entsprechenden Leiterbahnen und Trägermaterialien weltweit intensiv erforscht. Die Sintertemperaturen vieler Elektrokeramiken wurden dazu auf Temperaturen unter 1000 °C abgesenkt. Die sogenannten IPD's (= Integrated Passive Devices) werden aus Elektrokeramiken zusammen mit Glaskeramiken als Trägermaterialien und Metallen in Foliengieß- und Siebdrucktechnik geformt (Dougherty J. et. al.: The NEMI Roadmap Perspective on Integrated Passives, Abstract for IMAPS Europe 2001). Anschließend werden diese Werkstoffverbunde bei niedrigen Temperaturen gemeinsam im sogenannten LTCC-Verfahren gesintert (= Low Temperature Ceramic Cofiring) (Scrantom Ch. Q., Gravier G. J.: LTCC technology - Where we are and where we're going. June, 2000).

Einen noch wesentlich größeren Gestaltungsspielraum würde die gemeinsame Herstellung von Keramiken mit Polymeren oder Halbleitern eröffnen. Die dazu notwendige Absenkung der Sintertemperatur auf unter 100 °C ist jedoch durch eine Weiterentwicklung bestehender Sintertechniken nicht erreichbar.

Hiervon ausgehend ist deshalb die Aufgabe der vorliegenden Erfindung, ein neues Verfahren zur Festigkeitssteigerung von keramischen Formkörpern anzugeben, das die gemeinsame Herstellung von Keramiken mit Polymeren oder Halbleitern bei Sintertemperaturen unter 100 °C erlaubt. Weitere Aufgaben der Erfindung sind, nach diesem Verfahren hergestellte Formkörper bereit zu stellen sowie entsprechende Verwendungsmöglichkeiten derartiger keramischer Formkörper aufzuzeigen.

Die vorliegende Aufgabe wird durch das Verfahren mit den Merkmalen des Patentanspruchs 1 und dem hiernach hergestellten keramischen Formkörper mit den Merkmalen des Patentanspruchs 14 gelöst. Die weiteren Unteransprüche geben vorteilhafte Ausgestaltungsmöglichkeiten der Erfindung an. Die Ansprüche 16 und 17 geben erfindungsgemäße Verwendungen derartiger Formkörper an.

Erfindungsgemäß wird ein Verfahren zur Herstellung poröser keramischer Formkörper mit erhöhter Festigkeit bereitgestellt, bei dem der poröse keramische Formkörper mit einem mindestens eine Komponente des keramischen Materials zumindest teilweise lösenden Lösungsmittel infiltriert wird. Im Anschluss wird der derart präparierte Formkörper über einen Zeitraum von 1 Stunde bis zu 5 Tagen bei Temperaturen von ≤ 150 °C gelagert, um die Verfestigung des Formkörpers zu ermöglichen.

Überraschend wurde festgestellt, dass die Festigkeit von porösen keramischen Formkörpern, die aus Komponenten bestehen, von denen mindestens eine Komponente eine ausreichende Löslichkeit besitzt, durch einen Umfällungsprozess in einer in der Keramik fein dispergierten Flüssigkeit deutlich gesteigert werden kann.

Das Verfahren ist nicht auf eine spezielle Keramik beschränkt. Wichtig ist eine ausreichende Löslichkeit mindestens einer Komponente der Keramik in dem verwendeten Lösungsmittel. Die Flüssigkeit darf außerdem mit der Keramik keine thermodynamisch stabilere Verbindung im Vergleich zum Ausgangsmaterial bilden.

Die Wirksamkeit des Verfahrens hängt wesentlich davon ab, dass die Lösung innerhalb der porösen Keramik fein verteilt vorliegt. Eine vorteilhafte Ausgestaltung des Verfahrens sieht daher vor, dass sich die Flüssigkeit durch Kondensation aus der Gasphase im Poreninneren der keramischen Formkörper bildet, insbesondere an hygroskopischen wasserlöslichen Salzen.

Eine weitere vorteilhafte Ausgestaltung des Verfahrens besteht darin, dass die Flüssigkeit mit Hilfe von Mikrokapseln homogen mit dem keramischen Pulver vermischt und durch einen Formgebungsprozess in die Keramik eingebracht wird. Durch anschließendes Erwärmen oder unter Druck platzen die Mikrokapseln auf und geben die Flüssigkeit frei.

Eine weitere vorteilhafte Ausgestaltung des Verfahrens besteht darin, dass die Flüssigkeit in gefrorenem Zustand fein gemahlen mit dem keramischen Pulver gemischt wird und durch einen Formgebungsprozess in die Keramik eingebracht wird. Durch anschließendes Erwärmen taut die Flüssigkeit auf.

Des weiteren ist die Verwendung von keramischen Nanopulvern äußerst vorteilhaft, da diese eine besonders hohe Oberflächenenergie und damit auch eine hohe Löslichkeit besitzen.

Weiterhin sieht das Verfahren eine Lagerung der infiltrierten keramischen Formkörper bevorzugt bei Temperaturen ≤ 100 °C vor. Dabei können sich die Verweilzeiten über einen Zeitraum von 15 Minuten bis zu 30 Tagen erstrecken, bevorzugt über einen Zeitraum von 1 bis 10 Stunden.

Eine weitere vorteilhafte Ausgestaltung des Verfahrens besteht darin, dass während der Lagerung des keramischen Formkörpers eine Änderung des pH-Wertes der infiltrierten Flüssigkeit bewirkt wird.

Ein weiterer wichtiger Einflussparameter ist die Viskosität der Lösung, weil sie die Zeitdauer beeinflusst, in der das Lösungsmittel in fein dispergierter Form erhalten bleibt. Durch die hohe Oberflächenenergie der flüssigen Phase wird eine Umfällung von keramischem Material aus dem Bereich der Partikelkontaktflächen in den Porenraum begünstigt. Bei dieser Umfällung bilden sich ähnlich wie beim Flüssigphasensintern Korngrenzen zwischen den Partikeln aus, die zum erwünschten Anstieg der Festigkeit führen.

Die derart hergestellten keramischen Formkörper können vor der weiteren Verarbeitung gereinigt werden. Die Keramiken bleiben bei der Umfällung porös. Die Poren können jedoch nachträglich durch Infiltration (z. B. mit einem organischen Polymer) gefüllt werden, wenn die Anwendung dies erfordert.

Weiterhin können die keramischen Formkörper zur Herstellung von Verbundbauteilen mit Polymeren oder Halbleitern in der Elektronik oder Mikroelektronik als sogenannte IPD's (Integrated Passive Devices) bei Temperaturen unter 150 °C, bevorzugt bei Temperaturen unter 100 °C verwendet werden.

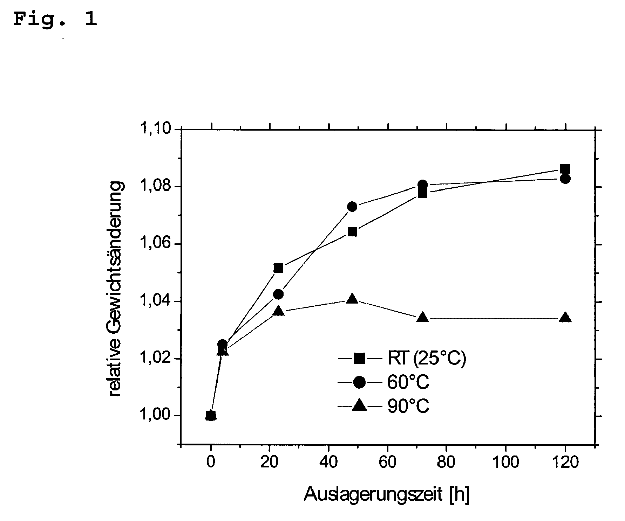

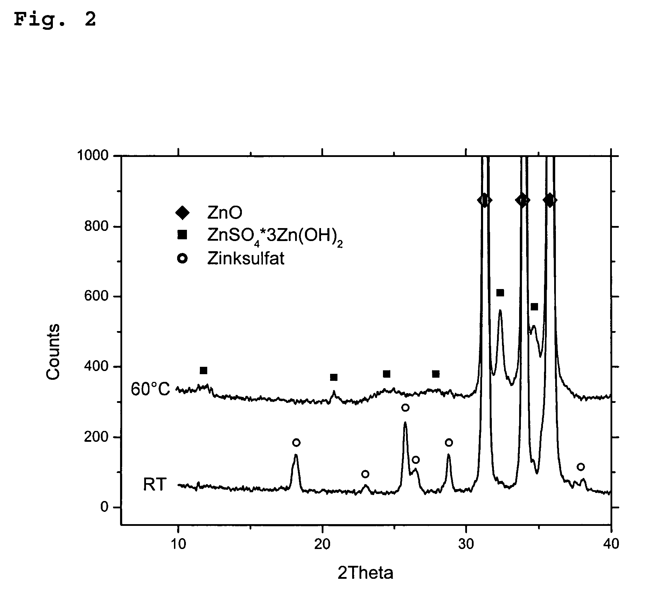

Die Erfindung wird nachfolgend anhand von zwei Beispielen und den Figuren 1 und 2 erläutert. Diese Beispiele betreffen spezielle Ausführungsformen der Erfindung und sollen die Erfindung in keiner Weise einschränken.

Fig. 1 zeigt ein Diagramm, in dem die relative Gewichtsänderung der erfindungsgemäßen Keramik in Abhängigkeit von der Auslagerungstemperatur bei unterschiedlichen Temperaturen dargestellt ist. Die Werte beziehen sich dabei auf eine relative Feuchte von 100 %.

Fig. 2 zeigt ein Röntgenspektrum einer erfindungsgemäßen Keramik, mit der Zusammensetzung von 90 Gew.-% ZnO und 10 Gew.-% ZnSO₄, die 120 h bei Raumtemperatur bzw. 60 °C gelagert wurde. Auch hier betrug die relative Feuchte 100 %.

### Beispiel 1

Herstellung einer Pulvermischung im Masseverhältnis ZnO : ZnSO₄ = 90 : 10

Zur Herstellung einer 100 g Pulvermischung wurden 90 g ZnO-Pulver und 10 g ZnSO₄ der Firma Fluca mit einer Partikelgröße von jeweils 1 - 3 µm zusammen mit 150 g Polyamid-Mahlkugeln mit einem Durchmesser von 10 mm in einem Taumelmischer 8 Stunden lang gemischt. Anschließend wurde die Pulvermischung in einer KaltIsostatischen-Presse bei einem Druck von 110 MPa zu Formkörpern mit einer theoretischen Dichte von 60 % und einem Durchmesser von 11 mm verdichtet. Aus dem Pressling wurden dann Tabletten mit einer Dicke von 4 mm gesägt.

Die so hergestellten Tabletten wurden bei unterschiedlichen Temperaturen bei 100 % Luftfeuchte für 120 Stunden ausgelagert. Der Wasserdampf kondensierte in dem porösen Formkörper, was sich durch eine deutliche Gewichtserhöhung mit der Zeit bis auf ca. 8 % bemerkbar machte. Die Ergebnisse sind in Fig. 1 dargestellt.

Die Festigkeit der Keramiken wurde durch Biegebruchversuche nach der sogenannten Ball-on-ring-Methode mit einem UTS-Testsystem bestimmt. Dazu wurden jeweils mindestens 10 etwa 0,5 mm dünnen Scheiben, die aus den Formkörpern durch Sägen und Nachschleifen der Oberflächen hergestellt wurden, vermessen.

Zunächst wurde die sogenannte Grünfestigkeit von unbehandelten Proben bei Raumtemperatur bestimmt. Ihr Mittelwert aus 10 Messungen betrug 8,3 MPa und wurde als 100-%-Referenzwert festgelegt. Anschließend wurden die Biegebruchfestigkeiten der für 120 Stunden bei 60 bzw. 90 °C und 100 % Luftfeuchte ausgelagerten Keramikproben gemessen, nachdem sie vorher in einem Exsiccator getrocknet worden waren. Dabei ergaben sich folgende Resultate:

| Auslagerungstemperatur in °C | Biegebruchfestigkeit in MPa (Mittelwert aus 10 Einzelmessungen) | Festigkeitssteigerung in % (bezogen auf 8,3 MPa Grünfestigkeit) |
|---|---|---|
| 60 | 58,7 | 707 |
| 90 | 27,0 | 325 |

Die Geometrie der Proben blieb bei dem Umfällungsprozess unverändert. Weiterhin konnten mittels Röntgenbeugung außer einer Hydratisierung des Zinksulfats keine Hinweise auf Fremdphasen gefunden werden (s. Fig. 2).

### Beispiel 2

Herstellung einer Pulvermischung im Masseverhältnis ZnO : ZnSO₄ = 95 : 5

Die Herstellung der Proben erfolgte analog zu Beispiel 1 mit dem oben angegebenen Mischungsverhältnis. Es ergaben sich folgende Resultate:

| Auslagerungstemperatur in °C | Biegebruchfestigkeit in MPa (Mittelwert aus 10 Einzelmessungen) | Festigkeitssteigerung in % (bezogen auf 8,6 MPA Grünfestigkeit) |
|---|---|---|
| 60 | 47,7 | 555 |
| 90 | 26,4 | 307 |

## Patentansprüche

1. Verfahren zur Herstellung poröser keramischer Formkörper mit erhöhter Festigkeit, bei dem der poröse keramische Formkörper mit einem mindestens eine Komponente des keramischen Materials zumindest teilweise lösenden Lösungsmittel infiltriert wird und im Anschluss über einen Zeitraum von 15 Minuten bis 30 Tagen bei Temperaturen von ≤ 150°C zur Verfestigung gelagert wird.

2. Verfahren nach Anspruch 1,
**dadurch gekennzeichnet, dass** das Lösungsmittel durch Kondensation aus der Gasphase im Poreninneren der keramischen Formkörper gebildet wird.

3. Verfahren nach Anspruch 2,
**dadurch gekennzeichnet, dass** mindestens eine Komponente des keramischen Materials ein hygroskopisches wasserlösliches Salz ist.

4. Verfahren nach Anspruch 1,
**dadurch gekennzeichnet, dass** das Lösungsmittel mit Hilfe von Mikrokapseln homogen mit dem keramischen Pulver vermischt wird und durch einen Formgebungsprozess der Formkörper mit dem Lösungsmittel infiltriert wird.

5. Verfahren nach Anspruch 4,
**dadurch gekennzeichnet, dass** die Mikrokapseln durch Temperatur oder Druckeinwirkung aufplatzen und das Lösungsmittel freigeben.

6. Verfahren nach Anspruch 1,
**dadurch gekennzeichnet, dass** das Lösungsmittel in gefrorenem Zustand fein gemahlen mit dem keramischen Material gemischt wird und durch einen Formgebungsprozess in den Formkörper eingebracht wird.

7. Verfahren nach Anspruch 6,
**dadurch gekennzeichnet, dass** durch Temperatureinfluss das Lösungsmittel aufgetaut wird.

8. Verfahren nach einem oder mehreren der vorhergehenden Ansprüche,
**dadurch gekennzeichnet, dass** als keramische Material keramische Nanopulver, insbesondere oxidische Pulver mit einer Partikelgröße < 100 nm, verwendet werden.

9. Verfahren nach einem oder mehreren der vorhergehenden Ansprüche,
**dadurch gekennzeichnet, dass** die infiltrierten keramischen Formkörper bei Temperaturen von ≤ 100 °C gelagert werden.

10. Verfahren nach einem oder mehreren der vorhergehenden Ansprüche,
**dadurch gekennzeichnet, dass** die infiltrierten keramischen Formkörper über einen Zeitraum von 1 bis 10 Stunden gelagert werden.

11. Verfahren nach einem oder mehreren der vorhergehenden Ansprüche,
**dadurch gekennzeichnet, dass** während der Lagerung des keramischen Formkörpers eine Änderung des pH-Werts des infiltrierten Lösungsmittels eintritt.

12. Verfahren nach einem oder mehreren der vorhergehenden Ansprüche,
**dadurch gekennzeichnet, dass** der keramische Formkörper im Anschluss, insbesondere durch Wässerung, gereinigt wird.

13. Verfahren nach einem oder mehreren der vorhergehenden Ansprüche,
**dadurch gekennzeichnet, dass** die Poren des keramischen Formkörpers durch Infiltration mit einem Polymer verschlossen werden.

14. Poröse keramische Formkörper, herstellbar nach dem Verfahren nach einem der Ansprüche 1 bis 13.

15. Formkörper nach Anspruch 14,
dass die Poren des Formkörpers durch Infiltration mit einem Polymer verschlossen sind.

16. Verwendung der keramischen Formkörper nach einem der Ansprüche 14 oder 15 zur Herstellung von Verbundbauteilen mit Polymeren oder Halbleitern bei Temperaturen von ≤ 150 °C.

17. Verwendung nach Anspruch 16 in der Elektronik oder Mikroelektronik als IPD's.
